# EUROPÄISCHE PATENTANMELDUNG

(11) **EP 2 990 638 A1**
(43) Veröffentlichungstag der Anmeldung: **02.03.2016**
(21) Anmeldenummer: 15185506.1
(22) Anmeldetag: 10.01.2013
(51) Int. Cl.: F02M 51/06, H01L 41/083, H01L 41/09, H01L 41/053, H02N 2/02, H02N 2/00

(54) **AKTORMODUL MIT EINEM IN EINEM GEHÄUSE ANGEORDNETEN VIELSCHICHTAKTOR UND KONSTANT EXTREM NIEDRIGEN LECKSTROM AN DER AKTOROBERFLÄCHE**

(30) Priorität: 11.01.2012 DE 102012200328
(62) Teilanmeldung aus: 13700162.4
(71) Anmelder: CeramTec GmbH, 73207 Plochingen (DE)
(72) Erfinder: Bindig, Reiner, 95463 Bindlach (DE); Schreiner, Dr. Hans-Jürgen, 91217 Hersbruck (DE)
(74) Vertreter: Uppena, Franz

(57) **Zusammenfassung**

Die Erfindung betrifft ein Aktormodul (22) mit einem in einem Gehäuse (23) angeordneten piezokeramischen Vielschichtaktor (1).

Damit es an der Aktoroberfläche auch nach langer Betriebsdauer zu keiner erhöhten Leitfähigkeit und damit ansteigendem Leckstrom kommt, wird erfindungsgemäß vorgeschlagen, dass das Gehäuse (23) hermetisch verschlossen ist und zwischen dem Vielschichtaktor (1) und dem Gehäuse (23) ein Raum (24) angeordnet ist, der mit einem Medium (21) teilgefüllt oder gefüllt ist, welches Wasser chemisch umwandelt und/oder bindet.

## Beschreibung

Die Erfindung betrifft ein Aktormodul mit einem in einem Gehäuse angeordneten piezokeramischen Vielschichtaktor.

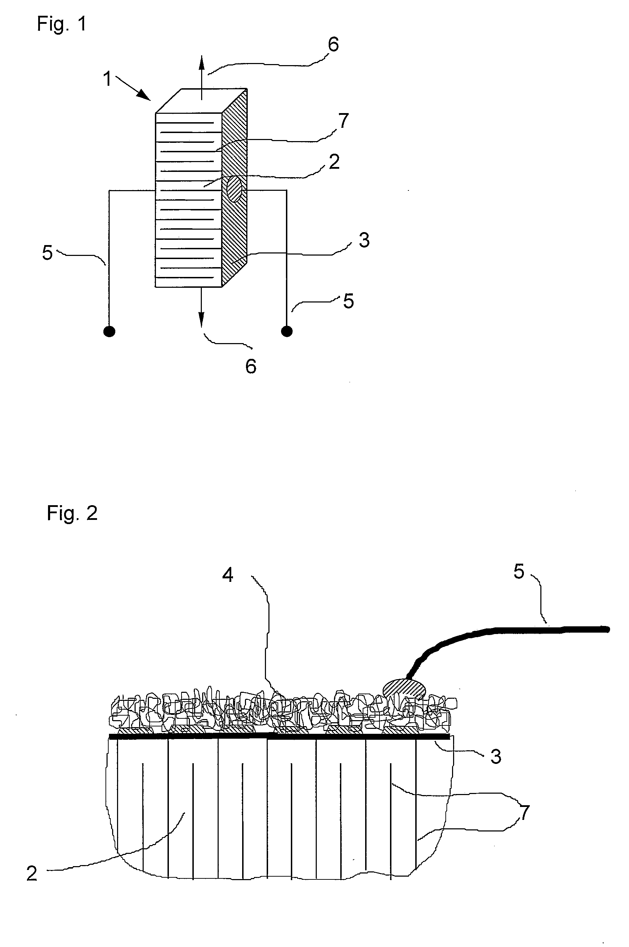

Bekannte piezokeramische Vielschichtaktoren 1 (siehe Figur 1) bestehen aus gestapelten dünnen Schichten piezoelektrisch aktiven Materials 2, z. B. Blei-Zirkonat-Titanat (PZT), mit dazwischen angeordneten leitfähigen Innenelektroden 7, die z. B. alternierend an die Aktoroberfläche geführt werden. Eine Grundmetallisierung 3 verbindet diese Innenelektroden 7. Dadurch werden die Innenelektroden 7 elektrisch parallel geschaltet und zu zwei Gruppen zusammengefasst, welche die beiden Anschlüsse 5 des Vielschichtaktors 1 darstellen. Legt man eine elektrische Spannung an die Anschlüsse 5, so wird diese auf alle Innenelektroden 7 parallel übertragen und verursacht ein elektrisches Feld in allen Schichten aktiven Materials 2, das sich dadurch mechanisch verformt. Die Summe aller dieser mechanischen Verformungen steht an den Endflächen des Aktors als nutzbare Dehnung 6 und/oder Kraft zur Verfügung.

Piezokeramische Vielschichtaktoren werden nach dem Stand der Technik als Monolithen ausgeführt, d. h. das aktive Material wird vor dem Sintern als sogenannte Grün-Folie durch ein Siebdruckverfahren mittels Edelmetallpaste mit Innenelektroden versehen, zu Aktorstapeln verpresst, pyrolysiert und dann gesintert, wodurch der monolithische Aktor entsteht.

Die Oberflächen des Aktorkörpers werden nun durch ein formgebendes Verfahren, im Allgemeinen durch Schleifen bearbeitet. Auf den Aktor (siehe Figur 2) wird im Bereich der herausgeführten Innenelektroden 7 z. B. durch galvanische Verfahren oder Siebdruck von Metallpaste eine Grundmetallisierung 3 aufgebracht. Diese Grundmetallisierung 3 wird verstärkt durch Aufbringen einer metallischen Außenelektrode 4 z. B. ein strukturiertes Blech, ein Drahtnetz oder Drahtgewebe. An diese Außenelektrode 4 wird der elektrische Anschluss 5 gelötet. Vor oder nach dem Anlöten der Anschlüsse 5 wird der Aktor mit einer elektrisch isolierenden Beschichtung überzogen, die zudem vor mechanischer Verletzung der Aktoroberflächen schützt.

Figur 1 zeigt einen piezokeramischen Vielschichtaktor nach dem Stand der Technik und Figur 2 zeigt als Verbesserung eine Außenelektrode 4 zwischen der Grundmetallisierung 3 und den Anschlüssen 5.

Der Aufbau und die Herstellung derartiger Aktoren und Außenelektroden wird ausführlich beschrieben z. B. in EP 0 844 678 B1, DE 33 30 538 A1, DE 40 36 287 C2, US 5 281 885, US 4 845 399, US 5 406 164 und JP 07-226541 A.

Viele Anwendungen für Vielschichtaktoren (nachfolgend auch allgemein als Aktoren bezeichnet) stellen die Forderung, dass der Aktor über lange Zeiträume mit der Nennspannung beaufschlagt werden kann, ohne dass er seine Eigenschaften ändert. Typisch Anwendungen sind Stell- und Positionierantriebe, die eine bestimmte Position anfahren, und unter Umständen über Monate und Jahre halten müssen. Diese Anforderung kann mit Aktoren nach dem oben beschriebenen Stand der Technik nicht erfüllt werden.

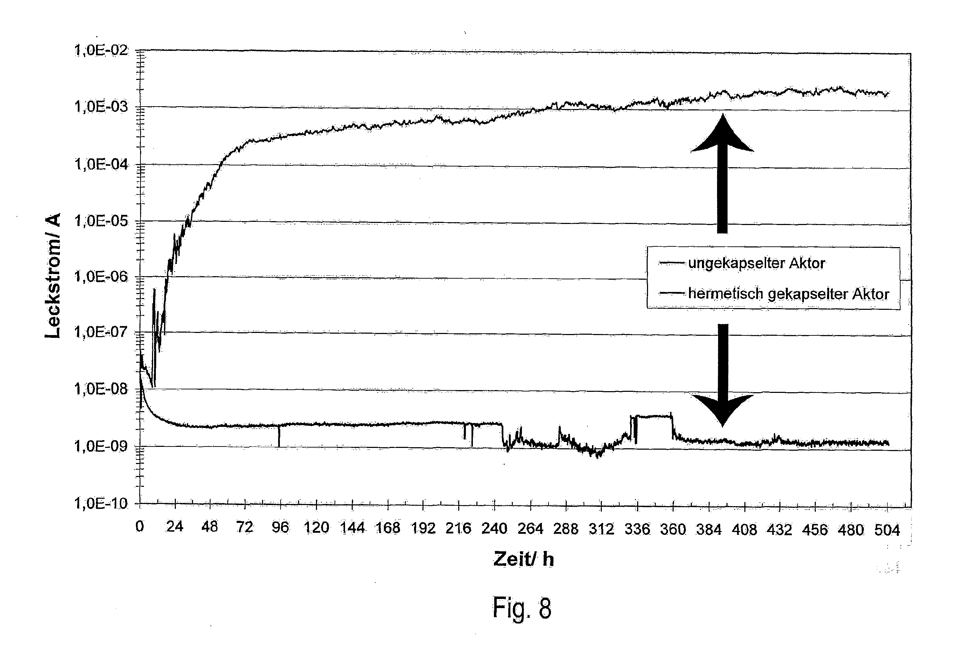

Ursache hierfür ist, dass durch die hohe elektrische Feldstärke an der Aktoroberfläche polare Moleküle, gewöhnlich Wasserdampf, aus der Umgebung angezogen werden. Dieser Wasserdampf durchdringt alle bekannten polymeren Umhüllungen mehr oder weniger schnell und führt schließlich an der Aktoroberfläche zu erhöhter Leitfähigkeit und zu ansteigendem Leckstrom. Der Leckstrom steigt so lange an bis sich durch die ebenfalls ansteigende Aktortemperatur ein Gleichgewicht für Wasserdampfadsorption durch das elektrische Feld und Desorption durch die Aktortemperatur einstellt. Den typischen Leckstromverlauf über der Zeit für einen Aktor mit den Abmessungen 7 x 7 x 30 mm³ bei einer inneren Feldstärke von 2000 V/mm unter normalen Laborumgebungsbedingungen zeigt das Diagramm in Figur 8.

Verwendet man als Überzug keramische Beschichtungen oder Gläser, so dringt der Wasserdampf durch Mikrorisse der Beschichtung, die sich zwangsläufig durch den Betrieb des Aktors bilden.

Auch das Umgießen mit einer geeigneten Vergussmasse in einem Metallgehäuse führt nicht zum Erfolg, da bereits die äußerst geringen Wassermengen die in der Vergussmasse enthalten sind, oder die während des Verkapselungsschrittes eindringen, genügen, den Effekt auszulösen.

Schwachpunkte bilden die immer notwendigen Dehnungsfugen an Boden und Deckel der Gehäuse, durch die Feuchtigkeit eindringt und die Anschlüsse bzw. Anschlussdrähte, die durch die Beschichtung beziehungsweise das Gehäuse nach außen geführt werden müssen. Die Verwendung von mit Kunststoffen isolierten Drähten führt aus oben genannten Gründen nicht zum Ziel.

Der Erfindung liegt die Aufgabe zugrunde, ein Aktormodul mit einem in einem Gehäuse angeordneten piezokeramischen Vielschichtaktor so zu verbessern, dass es an der Aktoroberfläche auch nach langer Betriebsdauer zu keiner erhöhten Leitfähigkeit und damit ansteigendem Leckstrom kommt.

Erfindungsgemäß wird diese Aufgabe durch die Merkmale des Anspruchs 1 gelöst.

Dadurch, dass das Gehäuse hermetisch verschlossenen ist und zwischen dem Vielschichtaktor und dem Gehäuse ein Raum angeordnet ist, der mit einem Medium teilgefüllt oder gefüllt ist, welches Wasser chemisch umwandelt und/oder bindet, kann eindringender Wasserdampf zu keiner erhöhten Leitfähigkeit und damit ansteigendem Leckstrom an der Aktoroberfläche führen. Mit dem Begriff Wasser wird auch Wasserdampf verstanden.

Durch das hermetisch verschlossene Gehäuse gelangt nur sehr wenig Wasser bzw. Wasserdampf in das Innere des Gehäuses und diese geringe Menge wird dann vom Medium umgewandelt oder gebunden und kann sich nicht auf der Aktoroberfläche absetzen.

Es gibt verschiedene Medien die geignet sind. In einer Auführungsform verbraucht das Medium Wasser reaktiv. Bevorzugt enthält das Medium Polyurethanharz oder besteht das Medium aus einem pulverisierten Trockenmittel.

In das Gehäuse sind elektrische Anschlüsse für den Vielschichtaktor geführt. Das Gehäuse besteht in bevorzugter Ausführungsform aus einem Gehäusedeckel, einem Gehäusemantel und einem Gehäuseboden. Bevorzugt sind die elektrischen Anschlüsse hermetisch und elektrisch isolierend in den Gehäuseboden integriert.

Dies geschieht in einer Ausgestaltung dadurch, dass der Gehäuseboden aus Metall besteht und die elektrischen Anschlüsse über eine Glasdurchführung oder Keramikdurchführung im Gehäuseboden in das Innere des Gehäuses geführt sind. Glasdurchführungen sind luftdicht und wasserdicht auszuführen.

Alternativ besteht der Gehäuseboden aus Keramik und weist metallisierte Durchbrüche auf in die die elektrischen Anschlüsse eingelötet sind. Bevorzugt weist der Gehäuseboden einen metallisierten Bereich am Außenumfang auf, über den eine hermetisch dichte Verbindung des Gehäusebodens mit dem Gehäusemantel erfolgt.

In einer Ausführungsform besteht der Gehäusedeckel aus Keramik und weist bevorzugt einen metallisierten Bereich am Außenumfang auf, über den eine hermetisch dichte Verbindung des Gehäusedeckels mit dem Gehäusemantel erfolgt.

Damit der Aktor sich ungehindert ausdehnen kann und dies zu keinen Schäden am Gehäuse führt, besteht der Gehäusemantel in einer bevorzugten Ausführungsform ganz oder teilweise aus einem Metallbalg.

Bevorzugt erzeugt der ganz oder teilweise aus einem Metallbalg bestehende Gehäusemantel die erforderliche mechanische Vorspannung für den Vielschichtaktor.

In einer Ausführungsform besteht der Gehäusemantel ganz oder teilweise aus Keramik und sind die elektrischen Anschlüsse im Gehäuseboden und/oder Gehäusedeckel angeordnet.

Der Gehäuseboden und/oder der Gehäusedeckel kann auch aus einer biegsamen Membran bestehen. In diesem Fall kann auf einen Metallbalg verzichtet werden.

Bevorzugt werden der Gehäuseboden, der Gehäusemantel und der Gehäusedeckel durch Verschweißen, insbesondere Laserschweißen, Hartlöten mit Metallot, Löten mit Glaslot oder Weichlöten hermetisch dicht verbunden.

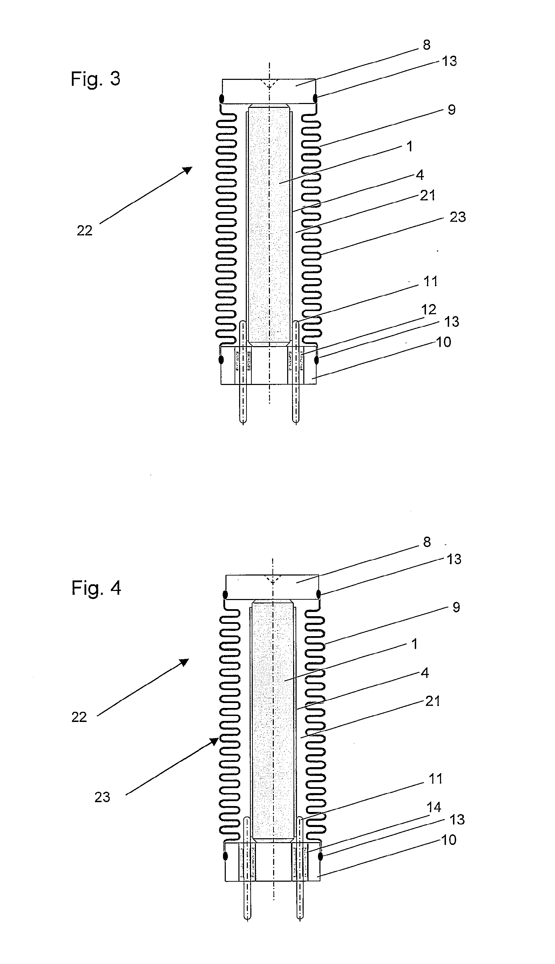

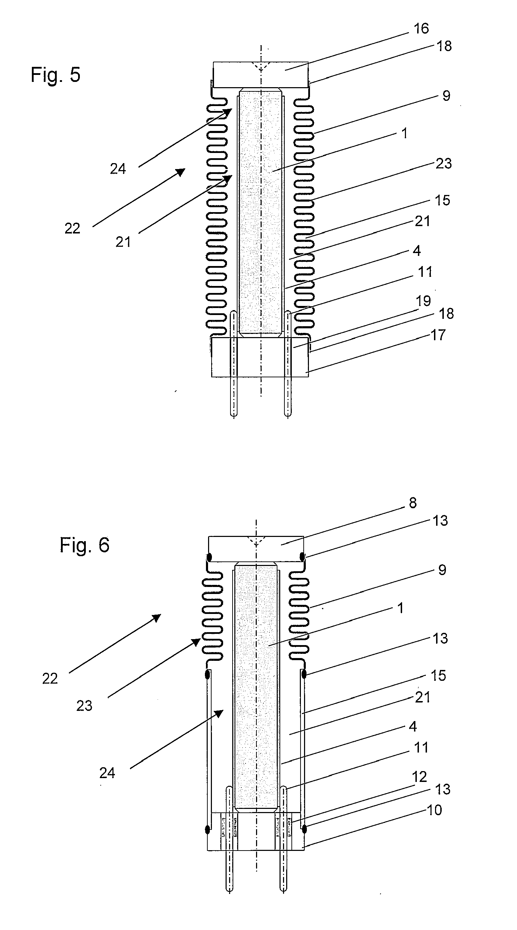

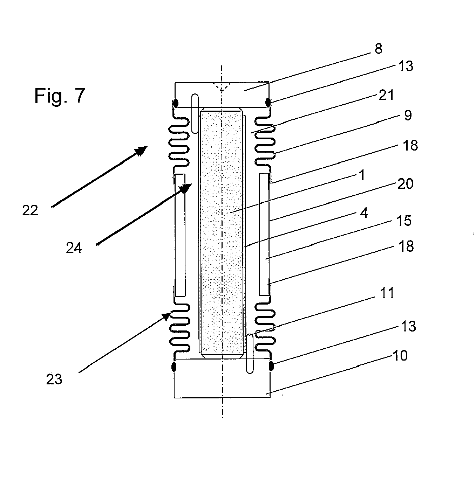

Nachfolgend wird die Erfindung anhand der Figuren 3 bis 7 weiter erläutert.

Mit Aktormodul wird die Einheit aus Aktor 1 und Gehäuse verstanden.

Es wird vorgeschlagen, piezokeramische Aktoren 1 in ein metallisches oder keramisches Gehäuse 23 einzubauen, bei dem die Anschlüsse 11 integrale Bestandteile des Gehäusebodens 10, 17 sind. Die Anschlüsse können beispielsweise mittels Glasdurchführungen 12 gasdicht gegen die Umgebung abgedichtet sein. Das Gehäuse 23 ist beispielsweise mittels Verschweißung 13 hermetisch dicht verschlossen. Die Gehäuseform ist so gewählt, dass eine kleine mechanische Vorspannung auf den Aktor 1 ausgeübt wird um ihn in Position zu halten. Das Gehäuse 23 muss zumindest teilweise nachgiebig sein, damit es dem Hub des Aktors 1 keinen zu großen Widerstand entgegensetzt. Das erreicht man, indem man das Gehäuse 23, bzw. den Gehäusemantel 9 als Metallbalg ausführt oder das Gehäuse 23 mit einer Metallmembran abschließt. Die Steifigkeit des Gehäuses ist vorzugsweise klein gegenüber der Aktorsteifigkeit.

In das Gehäuse 23 wird ein Medium 21 gegeben, das entweder die beim Verbau eingeschlossenen Wassermoleküle fixiert oder chemisch umwandelt. Für die Entstehung der Leckströme sind extrem kleine Wassermengen, wie sie typischerweise an Oberflächen adsorbiert sind, ausreichend. Daher ist es notwendig, diese kleinsten Wassermengen zu deaktivieren und das Gehäuse 23 durch Löten mit Metall oder Glas 18, 19 oder durch Schweißen 13 hermetisch dicht zu verschließen.

Dies führt zu folgenden Vorteilen:

Derartig hermetisch gekapselte Aktormodule 22 zeigen konstant extrem niedrige Leckströme, auch wenn sie permanent mit der Nennfeldstärke betrieben werden. Figur 8 zeigt als Diagramm den Leckstromverlauf an einem derart gekapselten Aktor 1. Aktorabmessungen und sonstige Parameter entsprechen dem ungekapselten Aktor gemäß Figur 8. Der Leckstrom des gekapselten Aktors 1 ist etwa 1.000.000 mal kleiner als der des ungekapselten Aktors.

Beim Herstellen des Aktors 1 wird eine niedrig sinternde Piezokeramik, z. B. nach DE 198 40 488 A1 mit einem organischen Bindersystem als 125 µm dicke Folie präpariert. Auf diese Folie wird eine handelsübliche Innenelektrodenpaste mittels Siebdruck aufgebracht. Eine Vielzahl derartiger Folien wird gestapelt und zu einem Laminat verpresst, wobei an Ober- und/oder Unterseite des Laminates einige Folien ohne Innenelektroden 7 bleiben, um einen inaktiven Bereich zu erzeugen, an dem der Aktor 1 später elektrisch kontaktiert werden kann. Das Laminat wird zu einzelnen, stabförmigen Aktoren zertrennt, diese werden bei 900 °C - 1100 °C, vorzugsweise bei 1000 °C gesintert. Nach dem Schleifen der Aktoroberflächen wird die Grundmetallisierung 3 aus Silber mittels eines Siebdruck/Einbrennprozesses auf die Kontaktseiten aufgebracht. Die Außenelektroden 4 aus Metalldraht-Netz werden darauf aufgelötet. Zum Schutz vor mechanischer Beschädigung und zur elektrischen Isolation bei den folgenden Messvorgängen werden die Aktoren 1 nun mit einem handelsüblichen Silikonlack isoliert. Die Aktoren 1 können nun polarisiert und elektrisch gemessen werden.

Ein Aktorgehäuse 23 wird hergestellt indem ein Metallbalg als Gehäusemantel 9 verwendet wird, der etwas kürzer ist als der Aktor 1. Beiderseits sind am Gehäusemantel 9 Bereiche vorgesehen, die das Anschweißen eines Gehäusedeckels 8 ermöglichen. Der Innendurchmesser des Gehäusemantels 9 bzw. des Metallbalgs ist derart, dass der Aktor 1 die Wandung des Gehäusemantels 9 nicht berührt, wenn er in den Metallbalg eingefügt wird.

Ein Gehäuseboden 10, 17 für das Gehäuse 23 wird hergestellt, indem in eine planparallele Metallscheibe zwei Bohrungen eingebracht werden. In diese Bohrungen werden beispielsweise durch Glaslot hermetisch dicht und elektrisch isolierend, Anschlussstifte als Anschlüsse 11 eingebracht. Es handelt sich um eine Glasdurchführung 12.

Als Gehäusedeckel 8 dient eine planparallele Metallscheibe ohne Bohrungen.

Der Aktor 1 wird nun auf dem Gehäuseboden 10, 17 mittels eines Epoxid- Klebstoffs so fixiert, dass er mit seinen Außenelektroden 4 mit den beiden Kontaktstiften als Anschlüsse 11 in Berührung kommt. Der Kontakt zwischen Außenelektrode 4 und den Kontaktstiften wird mittels Löten, Schweißen oder Kleben mit leitfähigem Kleber hergestellt.

Das Aktorgehäuse 23 wird über den Aktor 1 gesteckt, und mit dem Gehäuseboden 10, 17 z.B. mit einem Laser verschweißt. Der Aktor 1 ragt nun etwas über den Metallbalg als Gehäusemantel 9 hinaus. Er darf bei diesem Vorgang das Gehäuse 23 nicht berühren.

Der Zwischenraum bzw. Raum 24 zwischen Aktor 1 und Aktorgehäuse wird nun mit einem wasserverbrauchenden Medium 21 gefüllt, z.B. mit einem Polyurethanharz, das beim Aushärten Wasser aufnimmt und chemisch umwandelt und dabei beispielsweise CO₂ freisetzt.

Der Gehäusedeckel 8 wird nun auf den Aktor 1 gesetzt, das Gehäuse 9 wird an den Deckel 8 gezogen und z.B. mit Laserschweißen hermetisch dicht befestigt.

Die oben beschriebene Vorgehensweise bei der Herstellung monolithischer Vielschichtaktoren ist, wie in der Einführung beschrieben, in der Patentliteratur und sonstigen Veröffentlichungen ausführlich diskutiert. Das erfindungsgemäße Vorgehen bei der Kapselung der Aktoren muss nicht dem beschriebenen Arbeitsablauf entsprechen. Es sind für den Fachmann auch ähnliche Vorgehensweisen ableitbar, die zum gleichen Ergebnis führen.

Mit dem Begriff hermetisch wird luftdicht und wasserdicht verstanden.

Zeichnungen:
Fig. 1: Aufbau eines monolithischen Vielschichtaktors
Fig. 2: Detailansicht von Fig.1
Fig. 3: Hermetisch dichtes Gehäuse 23 mit Metallbalg als Gehäusemantel 9, Gehäusedeckel 8, Gehäuseboden 10 mit Kontaktstiften als Anschlüsse 11 in Glasdurchführungen 12. Das Gehäuse 23 ist verschweißt 13. Gehäusedeckel 8, Gehäusemantel 9 und Gehäuseboden 10 bestehen aus Metall.
Fig. 4: Hermetisch dichtes Gehäuse 23 mit Metallbalg als Gehäusemantel 9, Gehäusedeckel 8, Gehäuseboden 10 mit Kontaktstiften als Anschlüsse 11 in verlöteten Keramikdurchführungen 14. Das Gehäuse ist verschweißt 13.
Fig. 5: Hermetisch dichtes Gehäuse mit Metallbalg als Gehäusemantel 9, Keramikdeckel als Gehäusedeckel 16 mit Metallisierung am Umfang, Keramikboden als Gehäuseboden 17 mit Metallisierung am Umfang und eingelöteten Kontaktstiften als Anschlüsse 11. Das Gehäuse ist verlötet 18.
Fig. 6: Hermetisch dichtes Gehäuse mit zweiteiligem Gehäusemantel 9 aus Metallbalg und Metallrohr 15, die miteinander verschweißt sind, Gehäusedeckel 8 aus Metall, Gehäuseboden 10 aus Metall und mit Kontaktstiften als Anschlüsse 11 in Glasdurchführungen 12. Das Gehäuse ist verschweißt 13.
Fig. 7: Hermetisch dichtes Gehäuse mit dreiteiligem Gehäusemantel 9 aus zwei Metallbälgen die an ein teilweise metallisiertes Keramikrohr 20 gelötet sind, Gehäusedeckel 8 aus Metall und Gehäuseboden 10 aus Metall. Die Kontaktstifte als Anschlüsse 11 sind direkt mit den Außenelektroden 4 des Aktors 1 verbunden. Das Gehäuse ist verschweißt 13.
Figur 8: Leckstromverhalten eines Aktors 1 nach dem Stand der Technik ohne Gehäuse und Leckstromverhalten eines erfindungsgemäß gekapselten Aktors 1 als Aktormodul 22.

Bedeutung der einzelnen Bezeichnungen:
1: monolithischer piezokeramischer Vielschichtaktor
2: piezoelektrisch aktives Material
3: Grundmetallisierung
4: Außenelektrode
5: Anschlussdrähte für die Versorgungsspannung
6: Bewegungsrichtung des Aktors im Betrieb
7: Innenelektroden
8: Gehäusedeckel, Scheibe aus Metall
9: Gehäusemantel, Metallbalg
10: Gehäuseboden, Scheibe aus Metall mit Bohrungen
11: Anschlüsse, Kontaktstifte aus Metall
12: Glasdurchführung aus Glaslot
13: Verschweißung, Schweißnaht
14: Keramikdurchführung, metallisiertes Keramikröhrchen, mit Gehäuseboden und Kontaktstift verlötet
15: Metallrohr
16: Gehäusedeckel, Keramikscheibe, am Umfang metallisiert
17: Gehäuseboden, Keramikscheibe mit innen metallisierten Bohrungen, am Umfang metallisiert
18: Lötungen Metallbalg- Boden, Metallbalg- Deckel oder Metallbalg- Keramikrohr
19: Lötungen Kontaktstift- Boden
20: Keramikrohr, an beiden Enden am Umfang metallisiert
21: wasserbindendes oder -umwandelndes Medium als Füllung

## Patentansprüche

1. Aktormodul (22) mit einem in einem Gehäuse (23) angeordneten piezokeramischen Vielschichtaktor (1), **dadurch gekennzeichnet, dass** das Gehäuse (23) hermetisch verschlossen ist und zwischen dem Vielschichtaktor (1) und dem Gehäuse (23) ein Raum (24) angeordnet ist, der mit einem Medium (21) teilgefüllt oder gefüllt ist, welches Wasser chemisch umwandelt und/oder bindet, das Medium (21) Polyurethanharz enthält und in das Gehäuse (23) elektrische Anschlüsse (11) für den Vielschichtaktor (1) geführt sind, wobei das Gehäuse (23) aus einem Gehäusedeckel (8), einem Gehäusemantel (9) und einem Gehäuseboden (10, 17) besteht und die elektrischen Anschlüsse (11) hermetisch und elektrisch isolierend in den Gehäuseboden (10, 17) integriert sind.

2. Aktormodul nach Anspruch 1, **dadurch gekennzeichnet, dass** das Medium (21) Wasser reaktiv verbraucht.

3. Aktormodul nach Anspruch 1 oder 2, **dadurch gekennzeichnet, dass** das Medium (21) aus einem pulverisierten Trockenmittel besteht.

4. Aktormodul nach einem der vorhergehenden Ansprüche, **dadurch gekennzeichnet, dass** der Gehäuseboden aus Metall besteht und die elektrischen Anschlüsse über eine Glasdurchführung oder Keramikdurchführung im Gehäuseboden in das Innere des Gehäuses geführt sind.

5. Aktormodul nach einem der vorhergehenden Ansprüche, **dadurch gekennzeichnet, dass** der Gehäuseboden aus Keramik besteht und metallisierte Durchbrüche aufweist in die die elektrischen Anschlüsse eingelötet sind und bevorzugt der Gehäuseboden einen metallisierten Bereich am Außenumfang aufweist, über den eine hermetisch dichte Verbindung des Gehäusebodens mit dem Gehäusemantel erfolgt.

6. Aktormodul nach einem der vorhergehenden Ansprüche, **dadurch gekennzeichnet, dass** der Gehäusedeckel aus Keramik besteht und bevorzugt einen metallisierten Bereich am Außenumfang aufweist, über den eine hermetisch dichte Verbindung des Gehäusedeckels mit dem Gehäusemantel erfolgt.

7. Aktormodul nach einem der vorhergehenden Ansprüche, **dadurch gekennzeichnet, dass** der Gehäusemantel ganz oder teilweise aus einem Metallbalg besteht.

8. Aktormodul nach einem der vorhergehenden Ansprüche, **dadurch gekennzeichnet, dass** der ganz oder teilweise aus einem Metallbalg bestehende Gehäusemantel die erforderliche mechanische Vorspannung für den Vielschichtaktor erzeugt.

9. Aktormodul nach einem der vorhergehenden Ansprüche, **dadurch gekennzeichnet, dass** der Gehäusemantel ganz oder teilweise aus Keramik besteht und die elektrischen Anschlüsse im Gehäuseboden und/oder Gehäusedeckel angeordnet sind.

10. Aktormodul nach einem der vorhergehenden Ansprüche, **dadurch gekennzeichnet, dass** der Gehäuseboden und/oder der Gehäusedeckel aus einer biegsamen Membran bestehen.

11. Aktormodul nach einem der vorhergehenden Ansprüche, **dadurch gekennzeichnet, dass** der Gehäuseboden, der Gehäusemantel und der Gehäusedeckel durch Verschweißen, insbesondere Laserschweißen, Hartlöten mit Metallot, Löten mit Glaslot oder Weichlöten hermetisch dicht verbunden werden.
